(19) **Europäisches Patentamt European Patent Office Office européen des brevets**

(11) **EP 4 409 743 B1**

(12) **FASCICULE DE BREVET EUROPEEN**

(45) Date de publication et mention de la délivrance du brevet:
**18.02.2026 Bulletin 2026/08**

(21) Numéro de dépôt: **22789635.4**

(22) Date de dépôt: **15.09.2022**

(51) Classification Internationale des Brevets (IPC):
**H03H 9/02** *(2006.01)* **H03H 9/64** *(2006.01)*

(52) Classification Coopérative des Brevets (CPC):
**H03H 9/02637; H03H 9/02771; H03H 9/6493; H03H 9/6496;** H03H 9/02574; H03H 9/02653

(86) Numéro de dépôt international:
**PCT/FR2022/051736**

(87) Numéro de publication internationale:
**WO 2023/047042 (30.03.2023 Gazette 2023/13)**

(54) **FILTRE À ONDES ÉLASTIQUES DE SURFACE ET À CAVITÉS RÉSONANTES**

OBERFLÄCHENWELLENFILTER MIT ABSCHNITTEN STEHENDER WELLEN

SURFACE ACOUSTIC WAVE FILTER WITH RESONANT CAVITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2021 FR 2110135**

(43) Date de publication de la demande:
**07.08.2024 Bulletin 2024/32**

(73) Titulaire: **SOITEC**
**38190 Bernin (FR)**

(72) Inventeurs:
• **MICHOULIER, Eric**
**25000 Besançon (FR)**
• **BALLANDRAS, Sylvain**
**25000 Besançon (FR)**
• **LAROCHE, Thierry**
**25000 Besançon (FR)**

(74) Mandataire: **Grünecker Patent- und Rechtsanwälte PartG mbB Leopoldstraße 4 80802 München (DE)**

(56) Documents cités:
**EP-A1- 3 599 720** **WO-A1-2021/044031**
**DE-A1- 2 363 701** **US-A- 4 290 033**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

### DOMAINE DE L'INVENTION

La présente invention concerne un filtre à ondes élastiques de surface et à cavités résonantes. Un tel filtre trouve son application dans le domaine du traitement des signaux hautes fréquences, par exemple dans des applications de télécommunication.

### ARRIERE PLAN TECHNOLOGIQUE DE L'INVENTION

En référence à la figure 1, et comme cela est par exemple connu de EP0608249, un tel filtre 1 comprend typiquement, agencés sur un substrat piézoélectrique, au moins deux transducteurs électroacoustiques 2a, 2b, respectivement d'entrée et de sortie. Les deux transducteurs définissent un trajet le long duquel des ondes élastiques de surface se propagent. Ils forment également les ports électriques d'entrée Pe et de sortie Ps du filtre 1.

Le filtre 1 peut comprendre deux réseaux réfléchissants externes 3a, 3b (et préférentiellement uniquement réfléchissant), typiquement des miroirs de Bragg, disposés de part et d'autre du couple de transducteurs d'entrée 2a et de sortie 2b, selon l'axe X de propagation des ondes élastiques.

Le filtre 1 comprend au moins un réseau réfléchissant interne 4, disposé entre les deux transducteurs 2a, 2b, sur le trajet X des ondes élastiques et qui peut être équidistant de ces deux transducteurs 2a, 2b. Ce au moins un réseau réfléchissant interne 4 présente un coefficient de transmission non nul.

On définit de la sorte une pluralité de cavités résonantes C1, C2 le long du trajet de propagation des ondes, ces cavités résonantes formant autant de pôles du filtre 1.

Les documents EP3599720 et DE2363701 divulguent également plusieurs configurations d'un filtre à ondes élastiques de surface et à cavités résonantes.

Le document WO2020021029 propose de nombreuses configurations avantageuses d'un tel filtre à onde élastique de surface et à cavités résonantes, ces configurations étant toutes réalisées sur un substrat composite, c'est-à-dire un substrat formé d'un substrat de base (constituant un support mécanique) et d'une couche supérieure piézoélectrique. Les ondes élastiques se propagent dans la couche supérieure sous la forme d'ondes longitudinales et/ou de cisaillement. L'épaisseur de la couche supérieure est choisie pour être de l'ordre de grandeur de la longueur d'onde centrale du filtre ou inférieure à cette longueur d'onde. La propagation se réalise alors sans pertes de rayonnement dans le substrat de base.

La structure très générale du filtre proposée par le document précité permet de synthétiser une grande variété de filtres passe-bande présentant une perte d'insertion faible (<2dB) dans la bande passante et un taux de rejet important (>15dB) en dehors de cette bande.

Il est bien connu (voir par exemple EP0608249) que la synthèse d'un filtre à onde élastique de surface et à cavités résonantes peut provoquer l'apparition de lobes secondaires dans la bande de réjection ou de transition du filtre. Ces lobes sont d'amplitudes d'autant plus élevées que l'on cherche à élargir la bande passante relative du filtre.

Il serait donc souhaitable de disposer d'une structure de filtre qui puisse limiter l'amplitude des lobes présents dans la bande de réjection ou de transition.

### OBJET DE L'INVENTION

Un but de l'invention est de proposer une structure de filtre permettant d'adresser ce souhait. Plus précisément, un but de l'invention est de proposer une structure de filtre réduisant l'amplitude a hauteur des lobes présents dans la bande de réjection ou de transition par rapport aux structures de filtres de l'état de la technique.

### BREVE DESCRIPTION DE L'INVENTION

En vue de la réalisation de ce but, l'objet de l'invention propose un filtre à ondes élastiques de surface et à cavités résonantes comprenant :

- un substrat composite formé d'un substrat de base et d'une couche supérieure piézoélectrique ;
- au moins un transducteur électroacoustique d'entrée et un transducteur électroacoustique de sortie, disposés sur la couche supérieure ;
- au moins une structure réfléchissante interne, disposée entre le transducteur électroacoustique d'entrée et le transducteur électroacoustique de sortie.

La structure réfléchissante interne du filtre comprend :

- une première structure comprenant au moins un réseau réfléchissant présentant une première période ;

une deuxième structure comprenant au moins un réseau réfléchissant présentant une seconde période, la première période est supérieure à la seconde période ;

Selon l'invention, la première structure comprend une première pluralité de réseaux réfléchissants séparés les uns des autres d'une première distance, la deuxième structure comprend une deuxième pluralité de réseaux réfléchissants séparés les uns des autres d'une deuxième distance, et la première distance est inférieure à la deuxième distance.

Selon d'autres caractéristiques avantageuses et non limitatives de l'invention, prises seules ou selon toute combinaison techniquement réalisable :

- la première structure est distante du transducteur électroacoustique d'entrée d'une première distance de séparation, la deuxième structure est distante du transducteur de sortie d'une seconde distance de séparation, la première distance de séparation étant inférieure à la deuxième distance de séparation ;

- le filtre comprend en outre deux miroirs externes disposés de part et d'autre des transducteurs d'entrée et de sortie ;

- les réseaux réfléchissants et/ou les miroirs externes sont réalisés par des réseaux de doigts métalliques disposés sur/dans la couche supérieure du substrat composite ;

- les réseaux réfléchissants et/ou les miroirs externes sont réalisés par des réseaux de rainures gravées dans le substrat composite ;

- le substrat composite comprend au moins une couche disposée entre le substrat de base et la couche supérieure piézoélectrique ;

- le substrat de base présente une résistivité électrique supérieure à 1000 Ohm.cm ;

- l'épaisseur de la couche supérieure piézoélectrique est inférieure à 20 microns ;

- le transducteur électroacoustique d'entrée et le transducteur électroacoustique de sortie sont respectivement constitués de deux électrodes en peigne inter-digitées ;

- la distance séparant la première structure et la deuxième structure est égale à la moyenne arithmétique, à 10% près, de la première distance et la deuxième distance ;

## BREVE DESCRIPTION DES FIGURES

D'autres caractéristiques et avantages de l'invention ressortiront de la description détaillée de l'invention qui va suivre en référence aux figures annexées sur lesquels :

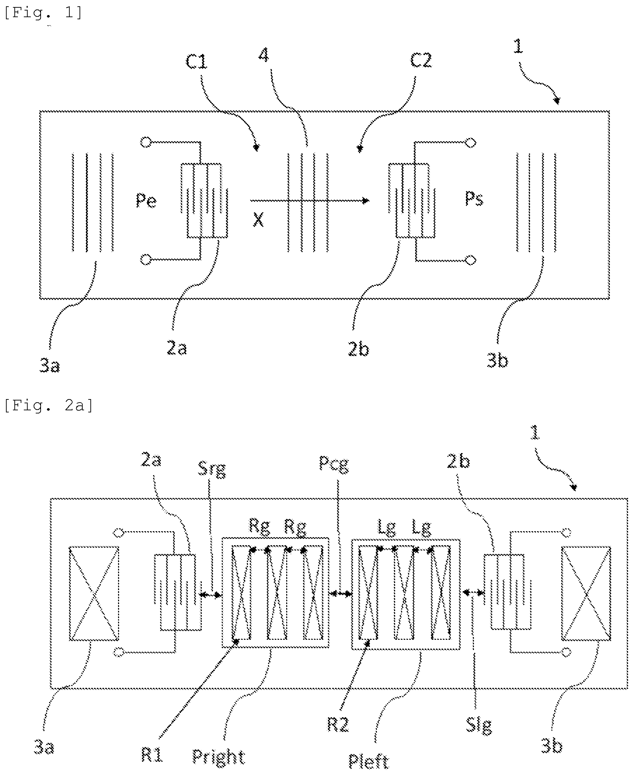

[Fig. 1] La figure 1 représente un filtre à ondes élastique de surface et à cavités résonantes de l'état de la technique ;

[Fig. 2a]

[Fig. 2b] Les figures 2a et 2b représentent, en vue schématique de dessus et en coupe, un filtre à ondes élastiques de surface et à cavités résonantes conforme à l'invention ;

[Fig. 3a] La figure 3a représente un filtre dont la structure est conforme à l'état de la technique ;

[Fig. 3b] La figure 3b représente le module de la fonction de transfert d'un filtre selon un premier contre-exemple ;

[Fig. 3c] La figure 3c représente la structure d'un filtre conforme à l'invention ;

[Fig. 3d] La figure 3d représente le module de la fonction de transfert d'un filtre d'un premier exemple de mise en œuvre de l'invention ;

[Fig. 4a] La figure 4a représente le module de la fonction de transfert d'un filtre selon un deuxième contre-exemple ;

[Fig. 4b] La figure 4b représente le module de la fonction de transfert d'un filtre d'un deuxième exemple de mise en œuvre de l'invention.

## DESCRIPTION DETAILLEE DE L'INVENTION

Par souci de simplification de la description à venir, les mêmes références sont utilisées pour des éléments identiques ou assurant la même fonction dans les différents modes de mise en œuvre exposés de l'invention et dans l'état de la technique.

Le filtre qui sera décrit dans la suite de cette description est réalisé sur un substrat composite formé d'un substrat de base et d'une couche supérieure piézoélectrique qui repose sur ce substrat de base. On peut prévoir d'autres couches entre ces deux éléments. Il peut par exemple s'agir d'une ou d'une pluralité de couche(s) amorphe(s) facilitant leur assemblage. Cette couche amorphe (ou la pluralité de couches amorphes) peut être, ou comprendre, de l'oxyde de silicium. L'épaisseur de la couche amorphe peut être supérieure ou inférieure à 200nm d'épaisseur, en particulier elle peut être choisie entre 10 nm et 6 microns. On peut également placer entre la couche supérieure et le substrat de silicium un miroir de Bragg formé d'un empilement de couches à impédance élastique périodiquement alternée.

La couche supérieure piézoélectrique du substrat composite peut être constituée de nitrure d'aluminium (AlN), d'oxyde de zinc (ZnO), de PZT, de niobate de potassium ($KNbO_3$) et de matériaux similaires tels que du KTN, du PMN-PT et les matériaux apparentés, le nitrure de gallium (GaN), le tantalate de lithium ($LiTaO_3$) ou le niobate de lithium $LiNbO_3$. De préférence, l'orientation cristallographique du tantalate de lithium ($LiTaO_3$) ou du niobate de lithium ($LiNbO_3$) est définie comme (YXl)/θ selon la norme IEEE 1949 Std-176, θ étant un angle d'orientation cristallographique compris entre 0° et 60° ou entre 90° et 150° ; Y et X étant les axes cristallins, et l représentant la longueur d'une plaque colinéaire à X autour de laquelle la rotation θ est réalisée.

Le substrat de base du substrat composite peut être un substrat à haute résistivité électrique, en particulier un substrat en silicium. Par haute résistivité, on entend une résistivité électrique de plus de 1000 Ohm.cm. On peut prévoir que le substrat de base comprenne une couche supérieure de piégeage des charges électriques, par exemple une couche de silicium polycristallin. Le substrat composite peut également être en carbone diamant, en saphir, en verre ou en carbure de silicium.

Le substrat composite peut être formé de multiples manières, et notamment par l'intermédiaire de la technologie Smart Cut™. Selon cette technologie, on définit une couche mince à transférer dans un substrat donneur piézoélectrique par implantation ionique d'espèces légères (hydrogène et/ou hélium par exemple) à travers une face principale de ce substrat donneur. Cette implantation forme une zone fragile définissant la couche mince avec la face principale du substrat. On assemble le substrat donneur, par sa face principale, au substrat de base, et on fracture le substrat donneur au niveau de la zone fragile pour transférer la couche mince, par exemple à l'aide d'un traitement thermique et/ou mécanique.

Alternativement à cette approche, et notamment lorsque la couche supérieure piézoélectrique du substrat composite est relativement épaisse, de l'ordre de 5 microns à 20 microns ou plus, on peut former le substrat composite par assemblage d'un substrat donneur au substrat de base et amincissement du substrat donneur, par exemple par CMP, meulage, polissage.

Dans tous les cas, et quelle que soit l'approche retenue, le transfert de la couche mince conduit à former un substrat composite formé d'une couche supérieure piézoélectrique monocristallin sur le substrat de base.

L'épaisseur de la couche supérieure piézoélectrique est de l'ordre de grandeur de la longueur de l'onde élastique qui est destinée à s'y propager. Préférentiellement, l'épaisseur de la couche supérieure piézoélectrique est moindre que cette longueur d'onde, par exemple environ 20 microns ou moins. L'épaisseur du substrat de base est quant à lui bien supérieure à l'épaisseur de la couche supérieure piézoélectrique, et typiquement au moins dix fois ou cent fois supérieure à cette couche, par exemple entre 250 microns et 500 microns.

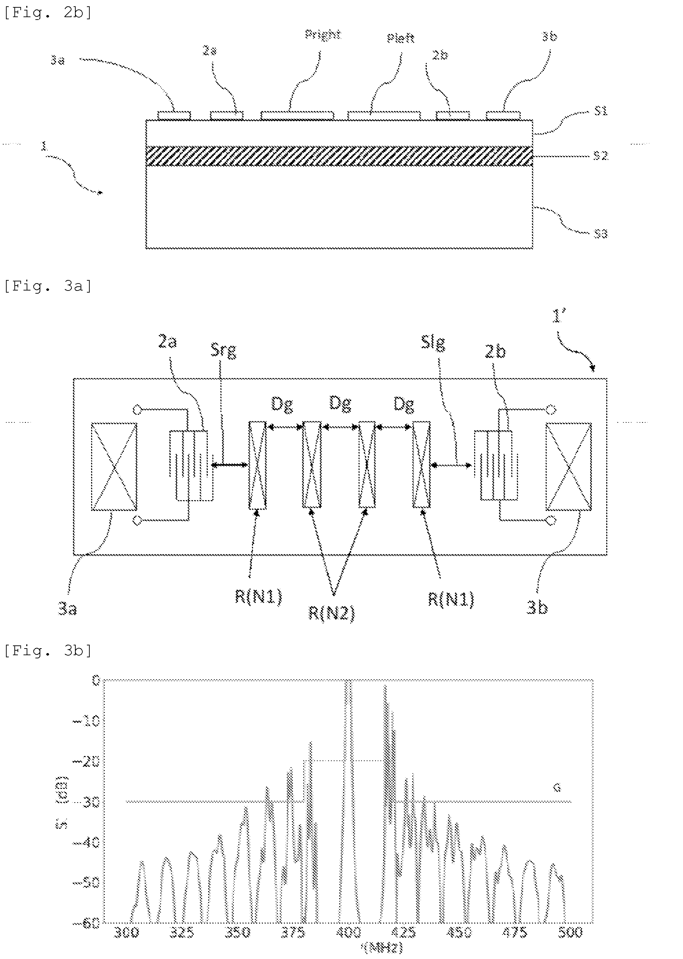

Les figures 2a et 2b représentent un filtre à ondes élastiques de surface et à cavités résonantes 1, qui fait l'objet de la présente description. Ce filtre 1 est réalisé sur ou dans la couche supérieure piézoélectrique S1 du substrat composite S, de manière conventionnelle, ici assemblé à un support S3 par l'intermédiaire d'une couche d'assemblage S2. On pourra se référer à l'ouvrage « Surface acoustic wave filters with application to electronic communications and signal processing » de David P. Morgan Academic Press; 2nd edition (August 9, 2007) pour obtenir les principes généraux permettant la synthèse d'un tel filtre à ondes élastiques de surface.

Le filtre est un filtre passe-bande qui présente une fréquence centrale $f_0$ et une largeur de bande passante $\Delta f$ qui peut s'exprimer comme une fraction de cette fréquence centrale, typiquement comprise entre 0.1% et 10%.

Le filtre 1 comprend au moins un transducteur électroacoustique d'entrée 2a et un transducteur électroacoustique de sortie 2b. Le signal électromagnétique à filtrer est appliqué sur le transducteur électroacoustique d'entrée 2a et le signal électromagnétique filtré est prélevé sur le transducteur électroacoustique de sortie 2b. Ces deux transducteurs forment donc respectivement un port d'entrée et un port de sortie du filtre. On note toutefois que la désignation « d'entrée » et « de sortie » est parfaitement arbitraire et que le filtre peut être exploité en appliquant/prélevant indifféremment un signal électromagnétique sur l'un ou l'autre des deux ports.

D'une manière très générale, les transducteurs 2a, 2b sont conformes à ceux connus de l'état de la technique, dont on rappelle quelques caractéristiques ci-après.

Chaque transducteur 2a, 2b est ici constitué de deux électrodes en peigne inter-digité. Comme cela est bien connu en soi, de tels transducteurs 2a, 2b sont constitués d'un réseau de doigts métalliques qui sont alternativement reliés à deux bus entre lesquels une différence de potentiel électrique est appliquée/prélevée. Avec ce dispositif on peut générer/détecter directement une onde élastique de surface dans la couche supérieure piézoélectrique. Les transducteurs d'entrée 2a et de sortie 2b sont généralement configurés pour être identiques, mais il n'est pas exclu qu'ils diffèrent, notamment en vue d'optimiser la réponse du filtre.

Le métal des électrodes est typiquement à base d'aluminium, par exemple de l'aluminium pur ou un alliage d'aluminium tel que l'aluminium dopé avec Cu, Si ou Ti. Il est néanmoins possible d'utiliser un autre matériau, par exemple pour établir un coefficient de réflexion plus élevé pour une épaisseur relative d'électrode plus faible. À cet égard, les matériaux d'électrode préférés sont le cuivre (Cu), le molybdène (Mo), le nickel (Ni), le platine (Pt) ou l'or (Au) avec une couche d'adhérence telle que le titane (Ti) ou le tantale (Ta) ou le chrome (Cr), le zirconium (Zr), le palladium (Pd), l'iridium (Ir), le tungstène (W), etc.

La période p des électrodes est généralement choisie telle que $p = \lambda/2$, $\lambda$ étant la longueur d'onde de l'onde élastique qui se propage dans la couche supérieure piézoélectrique à la fréquence de résonance $f_r$ du transducteur. D'autres configurations sont possibles, et plus généralement la période p peut s'écrire comme $p = \lambda/(nb\_elec)$, avec nb_elec le nombre de doigts (électrodes) par longueur d'onde. Ces paramètres sont reliés par la relation $\lambda = V/f_r$, dans laquelle V représente la vitesse de phase de l'onde élastique sous le transducteur. La vitesse de l'onde élastique en surface libre ou sous un transducteur électroacoustique dépend notamment de la nature du matériau dans lequel l'onde se propage, et elle est généralement connue ou accessible à la personne du métier.

Dans le cas du filtre passe-bande qui fait l'objet de cette description, on fixe la fréquence de résonance $f_r$ dans la bande passante du filtre ou, de préférence, à une fréquence inférieure à la borne inférieure de cette bande. En fixant cette fréquence de résonance, on peut déterminer la longueur d'onde λ de l'onde et donc la période p du transducteur.

La largeur de métallisation des électrodes, notée a, est généralement choisie pour que le ratio a/p soit de l'ordre de 0,5. Le nombre de paires de doigts de chaque transducteur est usuellement choisi de l'ordre de 20 ou 100. D'une manière générale, augmenter le nombre de paires de doigts permet d'augmenter le rejet des fréquences hors de la bande passante.

Revenant à la description générale du filtre représenté sur la figure 2, on peut prévoir deux miroirs externes 3a, 3b disposés de part et d'autre du couple des transducteurs d'entrée 2a et de sortie 2b. Comme cela est bien connu, ces miroirs 3a, 3b permettent de confiner un maximum de l'énergie élastique entre les deux transducteurs électroacoustiques d'entrée 2a et de sortie 2b. À ce titre, ils sont conçus pour présenter un coefficient de réflexion très important, aussi proche que possible de 1 (réflexion totale de l'énergie incidente), en choisissant l'épaisseur métallique des doigts des miroirs et le nombre de ces doigts, typiquement quelques dizaines par miroir dans le cas d'un substrat composite pour une onde de cisaillement. On note toutefois que ces deux miroirs externes ne sont nullement essentiels à l'invention, et qu'un filtre conforme à l'invention et entièrement fonctionnel peut en être dépourvu.

Pour finir la description du filtre représenté sur la figure 2, celui-ci comprend également, disposé entre le transducteur électroacoustique d'entrée 2a et le transducteur électroacoustique de sortie 2b, au moins une structure réfléchissante interne. La structure réfléchissante est constituée d'une pluralité de réseaux réfléchissants R1, R2 répartis le long du chemin de propagation des ondes élastiques. Comme cela a été rappelé en introduction de cette demande, cette structure définit une pluralité de cavités résonantes le long du trajet de propagation des ondes élastiques, ces cavités résonantes formant autant de pôles du filtre 1.

Chaque réseau réfléchissant R1, R2 de la structure réfléchissante interne est formé de réflecteurs de Bragg composés de doigts métalliques préférentiellement court-circuités. La période du réseau de doigts qui constituent chaque réseau réfléchissant R1, R2 est généralement choisie proche (à 15% près) de la période des électrodes des transducteurs, et donc généralement proche de λ/2. En choisissant la période des réseaux réfléchissants R1, R2 inférieure à celle des transducteurs, on rejettera mieux les signaux présentant une fréquence supérieure à celle de la bande passante du filtre, c'est-à-dire que la présence de lobes secondaires sera repoussée dans des plus hautes fréquences. Inversement, en choisissant la période des réseaux réfléchissants R1, R2 supérieure à celle des transducteurs, on rejettera mieux les signaux présentant une fréquence inférieure à celle de la bande passante du filtre, c'est-à-dire que la présence de lobe secondaire sera repoussée dans des plus basses fréquences.

Le nombre de doigts métalliques de chaque réseau réfléchissant R1, R2 détermine le coefficient de réflexion du réseau, de valeur maximum égale à 1 (réflexion totale de l'onde incidente). Un coefficient de réflexion élevé, supérieur à 0,5 ou supérieur à 0,8, permet d'augmenter le rejet en fréquence en dehors de la bande passante. Il réduit toutefois la bande passante, ce qui peut être compensé, si cette réduction est excessive, en ajoutant un réseau réfléchissant à la structure réfléchissante interne (et donc un pôle dans le filtre). Typiquement, ce nombre de doigts de chaque structure réfléchissante peut être compris entre 10 et 40.

Dans le filtre 1 qui fait l'objet de la présente description, la structure réfléchissante interne comprend :

- une première structure Pright comprenant au moins un réseau réfléchissant R1 présentant une première période ;
- une deuxième structure Pleft comprenant au moins un réseau réfléchissant R2 présentant une seconde période, la seconde période étant distincte de la première.

Par convention, on posera que la première période, correspondant donc à la période du réseau réfléchissant R1 de la première structure Pright, est supérieure à la deuxième période, correspondant donc à la période du réseau réfléchissant R2 de la deuxième structure Pleft. Par « supérieur » on signifie que la première période est plus grande que la deuxième période d'au moins 5nm.

La première structure Pright présente une pluralité de réseaux réfléchissants R1, et chaque réseau réfléchissant présente la même première période.

Similairement, la deuxième structure Pleft comprend également une pluralité de réseaux réfléchissants R2 et chaque réseau réfléchissant présente la même deuxième période. Dans tous les cas, les périodes des réseaux réfléchissants de la première structure Pright sont supérieures aux périodes des réseaux réfléchissants de la deuxième structure Pleft.

Les réseaux réfléchissants R1 de la première structure Pright sont séparés les uns des autres par une première distance Rg. De même, les réseaux réfléchissants R2 de la deuxième structure Pleft sont séparés les uns des autres par une deuxième distance Lg. Dans cette configuration, la première distance Rg est inférieure à la deuxième distance Lg.

Préférentiellement, la première distance Rg est choisie inférieure à une distance seuil Dg, appelée « distance de Bragg » dans la présente description. Dans le même temps, la deuxième distance Lg est choisie supérieure à la distance de Bragg Dg. La première distance Rg et la deuxième distance Lg séparant les réseaux réfléchissants R1, R2 dans, respectivement, la première structure Pright et la deuxième structure Pleft, définissent les dimensions des cavités acoustiques.

Dans l'hypothèse où la période des réseaux réfléchissants est choisie proche de $\lambda/2$, la distance de Bragg est sensiblement égale à $\lambda/4$. Plus précisément, la distance de Bragg Dg est définie par la relation Dg = $(V'^*p_0)/(2^*V)$ dans laquelle V représente la vitesse de phase de l'onde élastique sous les réseaux réfléchissants, V' la vitesse de phase de l'onde élastique en surface libre et po la période d'un réseau réfléchissant dont le maximum de réflexion serait égal à la fréquence centrale f0 du filtre.

La première distance Rg peut être choisie inférieure à la distance de Bragg Dg d'un facteur Fr compris entre 0,5 et 1, c'est-à-dire Rg=Fr*Dg. Similairement, la deuxième distance Lg peut être choisie supérieure à la distance de Bragg Dg d'un facteur F1 compris entre 1 et 2, c'est-à-dire

$$Lg=Dg*F1.$$

La distance Pcg séparant la première et la deuxième structure peut être choisie égale à la moyenne arithmétique de la première et la deuxième distance Rg, Lg. Par « égale », on signifie égale à 10% près.

Préférentiellement également, la première structure Pright est distante du transducteur électroacoustique d'entrée 2a d'une première distance de séparation Srg, la deuxième structure Pleft est distante du transducteur de sortie 2b d'une seconde distance de séparation Slg, et la première distance de séparation Srg est inférieure à la deuxième distance de séparation Slg.

Le nombre de réseaux réfléchissants R1, R2 dans la première et la deuxième structures Pleft, Pright peut être choisi avec une grande liberté. Il définit le nombre de cavités élastiques (en plus de celles définies ci-dessus par la première et la deuxième distance de séparation Srg, Slg) et donc le nombre de pôles du filtre. Un nombre relativement important de réseaux réfléchissants R1, R2 permet donc de conformer le comportement du filtre à un gabarit déterminé avec une grande souplesse. Il n'est pas nécessaire d'avoir un même nombre de réseaux réfléchissants R1, R2 dans les deux structures Pleft, Pright. On pourra choisir typiquement, selon les contraintes de filtrage fourni par le gabarit déterminé, entre 2 et 10 réseaux réfléchissants R1, R2 dans chacune des structures Pleft, Pright. Les facteurs limitant le nombre de structures réfléchissantes R1, R2 seront les pertes ohmiques et de propagation acoustique.

En proposant une structure de filtre présentant les caractéristiques décrites précédemment, les inventeurs de la présente demande ont observé qu'il était alors possible de proposer un filtre passe-bande dont les lobes secondaires dans la bande de réjection ou de transition étaient particulièrement réduits (par exemple une réduction d'au moins 5dB et typiquement de l'ordre de 10dB) même pour une largeur de bande passante relativement élevée, de plus de 1% de largeur relative.

Ce comportement très avantageux d'un tel filtre est rendu apparent en comparant, dans les sections qui suivent de la description, la fonction de transfert d'un filtre conventionnel (contre-exemple) à la fonction de transfert d'un filtre synthétisé à l'aide d'une structure conforme à l'invention (exemple).

Dans tous les exemples et contre-exemples qui suivent, le substrat composite S comprend une couche S2 d'oxyde de silicium de 500nm d'épaisseur disposés entre une couche piézoélectrique S1 de LiTaO3 (YXl)/42° de 0,6 micron d'épaisseur et un substrat de base S3 de silicium (100).

Dans un tel substrat composite S, une onde élastique présentant les longueurs d'onde visées dans ces exemples se propage principalement sous la forme d'ondes de cisaillement.

Contre-exemple 1 : Filtre présentant une fréquence centrale de 400 MHz et 0,4% de bande passante relative

À la fréquence centrale du filtre, et dans le substrat composite précédemment défini, la longueur d'onde de l'onde élastique se propageant dans la couche supérieure S1 est de 10,9 microns.

La figure 3a représente un filtre 1' dont la structure est conforme à l'état de la technique. Il présente, formé sur le substrat composite S, un transducteur électroacoustique d'entrée 2a et un transducteur électroacoustique de sortie 2b et une structure réfléchissante interne composée ici de quatre réseaux réfléchissants R séparés les uns des autres d'une distance égale de la distance de Bragg Dg. Le filtre 1' comprend également deux miroirs externes 3a, 3b disposés de part et d'autre du couple de transducteurs d'entrée et de sortie 2a, 2b.

Les paramètres du filtre 1' pris en contre-exemple 1 ont été obtenus à l'issue d'une série de simulations d'un modèle de ce filtre visant à conformer sa fonction de transfert à un gabarit passe-bande G prédéterminé, représenté sur la figure 3b.

Ainsi, la période p des transducteurs électroacoustiques 2a, 2b d'entrée et de sortie a été choisie à 5,450 microns. La largeur de métallisation des électrodes est choisie pour que le ratio a/p soit fixé à 0,6. Le nombre de paires de doigts métalliques du transducteur électroacoustique d'entrée 2a et d'un transducteur électroacoustique de sortie 2b est fixé à 35.

La période de chaque miroir externe est fixée à 5,557 microns. Chaque miroir externe présente 40 doigts et un rapport a/p de 0,5. La distance séparant, respectivement, les miroirs externes du transducteur électroacoustique d'entrée et du transducteur électroacoustique de sortie est fixée à 2,110 microns.

Les réseaux réfléchissants R sont séparés les uns des autres d'une distance Dg de 2,938 microns, proche d'une distance de Bragg d'un quart de longueur d'onde. Le premier et le dernier de ces réseaux réfléchissants sont espacés, respectivement, du transducteur électroacoustique d'entrée et du transducteur électroacoustique de sortie d'une distance 3,36 microns. Les réseaux réfléchissants R présentent chacun 30 doigts métalliques.

Les périodes de ces réseaux réfléchissants 4 sont toutes identiques et égales à 5,557 microns.

La figure 3b représente le module de la fonction de transfert de ce filtre 1', tel qu'il a été obtenu à l'issue des simulations ayant conduit à sa synthèse. On observe que cette fonction de transfert se conforme bien au gabarit dans la bande passante, mais l'on observe également la présence d'une pluralité de lobes d'amplitudes particulièrement élevées dans la bande de réjection. La présence de ces lobes n'est pas désirable, comme cela a été rapporté par le document de l'état technique cité en introduction de cette demande.

Exemple 1 : Filtre présentant une fréquence centrale de 400MHz et 0,4% de bande passante relative

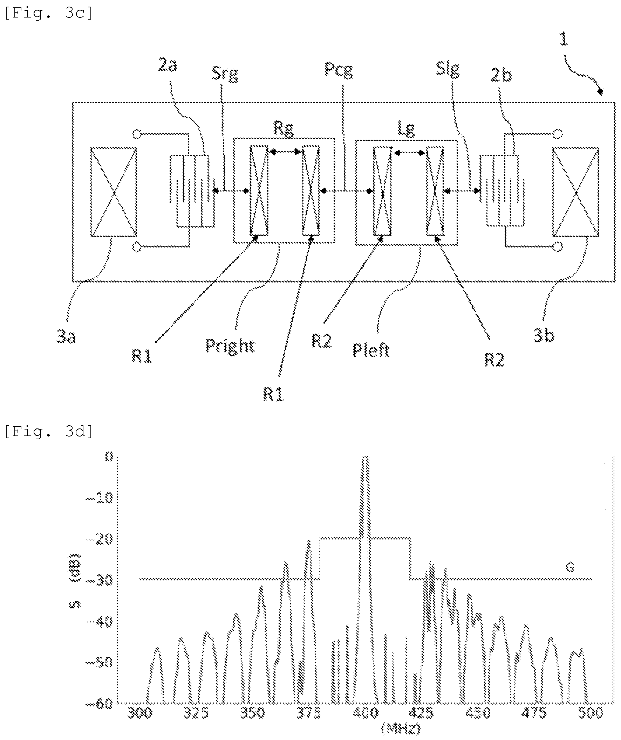

La figure 3d représente le module de la fonction de transfert d'un filtre 1 présentant la structure représentée sur la figure 3c conforme à la structure d'un filtre de l'invention.

Les paramètres du filtre 1 de l'exemple 1 ont été obtenus par simulation, tout comme ceux du contre-exemple 1. Tout comme le filtre 1' du contre-exemple 1, le filtre 1 présente également quatre réseaux réfléchissants R1, R2, deux étant disposés dans la première structure Pright et les deux autres étant disposés dans la deuxième structure Pleft. Les réseaux réfléchissants R1, R2 présentent chacun 30 doigts métalliques. Les autres paramètres obtenus par simulation de ce filtre 1 sont les suivants :

Première structure Pright :

- Srg : 2,645 microns
- Rg : 1,446 micron ce qui est bien inférieur à la distance de Bragg Dg de 2,938 microns
- Période des 2 réseaux réfléchissants R1 (la première période) : 5,686 microns

Deuxième structure Pleft :

- Slg : 4,350 microns
- Lg : 4,790 microns, ce qui est bien supérieur à la distance de Bragg Dg de 2,938 microns.
- Période des 2 réseaux réfléchissants R2 (la deuxième période) : 5,399 microns.

On observe que la première période des réseaux réfléchissants R1 de la première structure Pright est bien supérieure à la deuxième période des réseaux réfléchissants R2 de la deuxième structure Pleft.

La distance Pcg séparant la première structure Pright de la deuxième structure Pleft est de 3,125 microns, sensiblement égale à la moyenne arithmétique de la première distance Rg et la deuxième distance Lg (3,118 microns).

Les transducteurs électroacoustiques d'entrée et de sortie 2a, 2b présentent les mêmes paramètres que ceux du contre-exemple 1. La période de chaque miroir externe est fixée à 5,557 microns. Chaque miroir externe présente 40 doigts et un rapport a/p de 0.5. La distance séparant, respectivement, les miroirs externes du transducteur électroacoustique d'entrée et du transducteur électroacoustique de sortie est fixée à 1,800 microns.

La figure 3d représente le module de la fonction de transfert de ce filtre 1, tel qu'il a été obtenu par simulation. On observe que la fonction de transfert se conforme bien au gabarit dans la bande passante. De plus, et bien que des lobes soient encore présents dans la bande de réjection, ceux-ci sont d'amplitudes moindres et rejetés à des fréquences plus éloignées de la bande passante.

La performance du filtre 1 de cet exemple 1 est donc bien supérieure à la performance du filtre 1' du contre-exemple 1, dont la structure se conforme à une structure de filtre de l'état de la technique.

Contre-exemple 2 : Filtre présentant une fréquence centrale de 1900MHz et 3,5% de bande passante relative.

On cherche maintenant à synthétiser un filtre dont la bande passante relative est nettement plus large que celle de l'exemple 1 et du contre-exemple 1.

À la fréquence centrale du filtre, et dans le substrat composite S précédemment défini, la longueur d'onde de l'onde élastique se propageant dans la couche supérieure S1 est de 2,058 microns

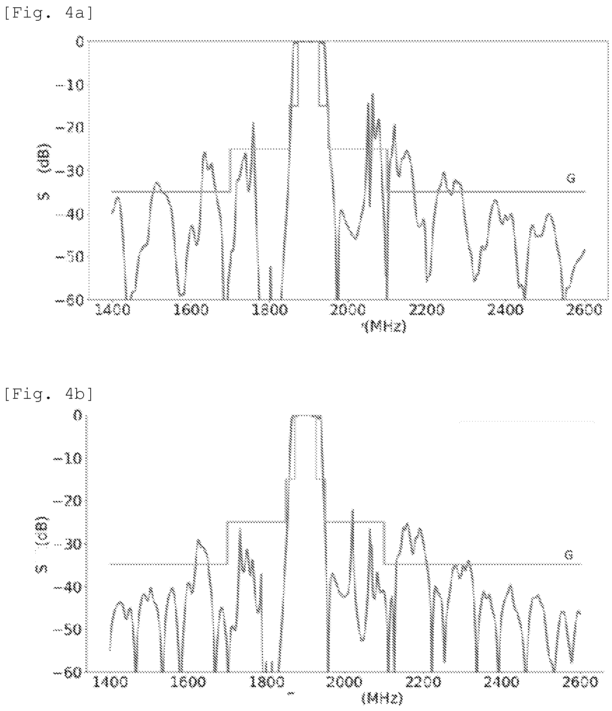

La structure du filtre du contre-exemple 2, identique à celui du contre-exemple 1, est représentée sur la figure 3a. Les paramètres du filtre 1' du contre-exemple 2 ont été obtenus à l'issue d'une série de simulations d'un modèle de ce filtre 1" visant à conformer sa fonction de transfert à un gabarit prédéterminé G, représenté sur la figure 4a.

La période p des transducteurs électroacoustiques d'entrée et de sortie a été choisie à 1,029 micron. La largeur de métallisation des électrodes est choisie pour que le ratio a/p soit fixé à 0,54. Le nombre de paires de doigts métalliques de chaque transducteur est fixé à 16.

La période de chaque miroir externe est fixée à 1,060 micron. Chaque miroir externe présente 25 doigts et un rapport a/p de 0,5 La distance séparant, respectivement, les miroirs externes du transducteur électroacoustique d'entrée et du transducteur électroacoustique de sortie est fixée à 0,301 micron.

Les quatre réseaux réfléchissants R présentent chacun 10 doigts métalliques. Les réseaux réfléchissants internes sont séparés par d'une distance Dg de 0,535 micron, correspondant à environ une distance de Bragg d'un quart de longueur d'onde. Le premier et le dernier de ces réseaux réfléchissants sont espacés, respectivement, du transducteur électroacoustique d'entrée et du transducteur électroacoustique de sortie d'une distance Srg, Slg de 0,594 micron.

Les périodes de ces réseaux 4 réfléchissants intérieurs et extérieurs sont toutes identiques et égales à 1,060 micron

La figure 4a représente le module de la fonction de transfert de ce filtre, tel qu'il a été obtenu par simulation. On observe qu'elle se conforme au gabarit prédéterminé dans la bande passante, mais, tout comme dans le contre-exemple 1, on observe la présence d'une pluralité de lobes, d'amplitudes particulièrement élevées dans la bande de réjection.

<u>Exemple 2 : Filtre présentant une fréquence centrale de 1900MHz et 3,5% de bande passante relative.</u>

La figure 4b représente le module de la fonction de transfert d'un filtre synthétisé par simulation à partir d'une structure de filtre représentée sur la figure 3c et conforme à la structure d'un filtre de l'invention.

Les quatre réseaux réfléchissants R1, R2 présentent chacun 11 doigts métalliques. Les autres paramètres également obtenus par simulation de ce filtre sont les suivants :

Première structure Pright :

- Srg : 0,496 micron
- Rg : 0,290 micron ce qui est bien inférieur à la distance de Bragg Dg de 0,593 micron
- Période des réseaux réfléchissants R1 (la première période): 1,100 micron

Deuxième structure Pleft :

- Slg : 0,767 micron
- Lg : 0,827 micron, ce qui est bien supérieur à la distance de Bragg Dg de 0,593 micron.
- Période des réseaux réfléchissants R2 (la deuxième période) : 1,009 micron

On observe que la première période du réseau réfléchissant R1 de la première structure Pright est bien supérieure à la deuxième période du réseau réfléchissant de la deuxième structure Pleft.

La distance Pcg séparant la première structure Pright de la deuxième structure Pleft est de 0,56 micron, sensiblement égale à la moyenne arithmétique de la première distance Rg et la deuxième distance Lg (0,558 micron).

La période p des transducteurs électroacoustiques d'entrée et de sortie a été choisie à 1,0214 micron. La largeur de métallisation des électrodes est choisie pour que le ratio a/p soit fixé à 0,545. Le transducteur d'entrée présente 16 paires de doigts et le transducteur de sortie présente 16 paires de doigts.

La période de chaque miroir externe est fixée à 1.06 micron. Chaque miroir externe présente 30 doigts et un rapport a/p de 0.5. La distance séparant, respectivement, les miroirs externes du transducteur électroacoustique d'entrée et du transducteur électroacoustique de sortie est fixée à 0.400 micron.

La figure 4b représente le module de la fonction de transfert de ce filtre, tel qu'il a été obtenu par simulation. On observe bien qu'il se conforme au gabarit dans la bande passante. De plus, et bien que des lobes soient encore présents dans la bande de réjection, ceux-ci sont d'amplitudes bien moindres et rejetés à des fréquences plus éloignées de la bande passante.

La performance de ce filtre est donc bien supérieure à la performance du filtre du contre-exemple 2 dont la structure se conforme à une structure de filtre de l'état de la technique.

La synthèse d'un filtre conforme à l'invention peut être simplifiée en la décomposant en plusieurs étapes.

Au cours d'une première étape, on procède à la synthèse d'un premier filtre incomplet comprenant le transducteur électroacoustique d'entrée 2a et le transducteur électroacoustique de sortie 2b, et uniquement l'une de la première structure Pright et de la deuxième structure Pleft. On peut naturellement intégrer les miroirs externes dans les simulations si de tels miroirs sont prévus dans le filtre complet 1. Les simulations réalisées au cours de cette première étape permettent d'établir les paramètres de la structure choisie, c'est à dire au moins la distance séparant les réseaux réfléchissants R1, R2 compris dans cette structure, le nombre et la configuration de ces réseaux.

Au cours d'une seconde étape, on procède à la synthèse d'un second filtre incomplet en incorporant cette fois uniquement celle, de la première ou la deuxième structure Pright, Pleft, qui n'a pas été retenue au cours de la première étape. Cette seconde étape permet d'établir les paramètres de cette structure de filtre, par simulations, comme cela a été réalisé au cours de la première étape.

Dans une dernière étape, on procède à la synthèse complète du filtre, en intégrant les paramètres déterminés aux première et seconde étapes dans la structure complète du filtre. Comme cela a déjà été mentionné précédemment, on pourra choisir la distance Pcg séparant la première structure Pright et la deuxième structure Pleft comme la moyenne arithmétique de la première distance Rg et la deuxième distance Lg. On pourra, au cours de cette dernière étape de synthèse, procéder à un nouveau cycle de simulations, pour vérifier la bonne concordance de la réponse du filtre et du gabarit et éventuellement d'ajuster finement certains paramètres.

Bien entendu l'invention n'est pas limitée au mode de mise en œuvre décrit et l'on peut y apporter des variantes de réalisation sans sortir du cadre de l'invention tel que défini par les revendications. Bien que l'on ait prévu ici de former les réseaux réfléchissants R1, R2 et les miroirs externes 3a, 3b à l'aide de réseaux de doigts métalliques ils peuvent alternativement être construits par des réseaux de rainures gravées dans le substrat composite. Ces rainures peuvent être gravées dans la couche supérieure piézoélectrique du substrat composite et atteindre le substrat de base. Les réseaux réfléchissants R1, R2 peuvent également être constitués d'obstacles diélectriques de forme identique aux doigts métalliques considérés jusqu'ici et déposés lors d'une phase spécifique de réalisation du filtre. Les matériaux d'intérêt pour réaliser ces miroirs sont le dioxyde de silicium (SiO2), le nitrure de silicium (Si3N4), les combinaisons de ces deux matériaux permettant de réaliser des couches dites d'oxy-nitrures de stœchiométrie spécifique (de forme générale $SiO_XN_Y$), l'oxyde d'aluminium (Al2O3), le nitrure d'aluminium (AlN), l'oxyde de Zirconium (ZrO2), l'oxyde d'hafnium (HfO2), le pentoxyde de tantale (Ta2O5) et, de façon générale, les oxydes pouvant être déposés sous forme de couche en surface des substrats d'intérêt selon les procédés de la microélectronique.

**Revendications**

1. Filtre (1) à ondes élastiques de surface et à cavités résonantes comprenant :

   - Un substrat composite (S) formé d'un substrat de base (S3) et d'une couche supérieure piézoélectrique (S1) ;
   - au moins un transducteur électroacoustique d'entrée (2a) et un transducteur électroacoustique de sortie (2b), disposés sur la couche supérieure ;
   - au moins une structure réfléchissante interne, disposée entre le transducteur électroacoustique d'entrée (2a) et le transducteur électroacoustique de sortie (2b)la structure réfléchissante interne comprenant :

      - une première structure (Pright) comprenant au moins un réseau réfléchissant (R1) présentant une première période ;
      - une deuxième structure (Pleft) comprenant au moins un réseau réfléchissant (R2) présentant une seconde période, la première période étant supérieure à la seconde période ;

   le filtre étant **caractérisé en ce que** :

      - la première structure (Pright) comprend une première pluralité de réseaux réfléchissants (R1) présentant la première période, séparés les uns des autres d'une première distance (Rg) ;
   - la deuxième structure (Pleft) comprend une deuxième pluralité de réseaux réfléchissants (R2) présentant la seconde période, séparés les uns des autres d'une deuxième distance (Lg);

   la première distance (Rg) étant inférieure à la deuxième distance (Lg).

2. Filtre (1) selon la revendication précédente dans lequel la première structure (Pright) est distante du transducteur électroacoustique d'entrée (2a) d'une première distance de séparation (Srg), la deuxième structure (Pleft) est distante du transducteur de sortie (2b) d'une seconde distance de séparation (Slg), la première distance de séparation (Srg) étant inférieure à la deuxième distance de séparation (Slg).

3. Filtre (1) selon l'une des revendications précédentes comprenant en outre deux miroirs externes (3a, 3b) disposés de part et d'autre des transducteurs d'entrée (2a) et de sortie (2b).

4. Filtre (1) selon l'une des revendications précédentes dans lequel les réseaux réfléchissants (R1, R2) et/ou les miroirs externes (3a, 3b) sont réalisés par des réseaux de doigts métalliques disposés sur/dans la couche supérieure du substrat composite (S).

5. Filtre (1) selon l'une des revendications 1 à 3 dans lequel les réseaux réfléchissants (R1, R2) et/ou les miroirs externes (3a, 3b) sont réalisés par des réseaux de rainures gravées dans le substrat composite.

6. Filtre (1) selon l'une des revendications 1 à 3 dans lequel les réseaux réfléchissants (R1, R2) et/ou les miroirs externes (3a, 3b) sont réalisés par des réseaux de doigts diélectriques disposés en surface du substrat composite (S).

7. Filtre (1) selon l'une des revendications précédentes dans lequel le substrat composite comprend au moins une couche (S2) disposée entre le substrat de base (S3) et la couche supérieure piézoélectrique (S1).

8. Filtre (1) selon l'une des revendications précédentes dans lequel le substrat de base (S3) présente une résistivité électrique supérieure à 1000 Ohm.cm.

9. Filtre (1) selon l'une des revendications précédentes dans lequel l'épaisseur de la couche supérieure (S3) piézoélectrique est inférieure à 20 microns.

10. Filtre (1) selon l'une des revendications précédentes dans lequel le transducteur électroacoustique d'entrée (2a) et le transducteur électroacoustique de sortie (2b) sont respectivement constitués de deux électrodes en peigne interdigitées.

11. Filtre (1) selon l'une des revendications précédentes dans lequel la distance (Pcg) séparant la première structure (Pright) et la deuxième structure (Pleft) est égale à la moyenne arithmétique, à 10% près, de la première distance (Rg) et la deuxième distance (Lg).

**Patentansprüche**

1. Filter (1) mit elastischen Oberflächenwellen und Resonanzhohlräumen, umfassend:

   - ein Verbundsubstrat (S), bestehend aus einem Basissubstrat (S3) und einer piezoelektrischen Deckschicht (S1);
   - mindestens einen elektroakustischen Eingangswandler (2a) und einen elektroakustischen Ausgangswandler (2b), die auf der Deckschicht angeordnet sind;
   - mindestens eine interne reflektierende Struktur, die zwischen dem elektroakustischen Eingangswandler (2a) und dem elektroakustischen Ausgangswandler (2b) angeordnet ist, wobei die interne reflektierende Struktur umfasst:

      - eine erste Struktur (Pright) mit mindestens einem reflektierenden Gitter (R1), die eine erste Periode aufweist;
      - eine zweite Struktur (Pleft) mit mindestens einem reflektierenden Gitter (R2), die eine zweite Periode aufweist,

   wobei die erste Periode größer ist als die zweite Periode; wobei das Filter **dadurch gekennzeichnet ist, dass**:

      - die erste Struktur (Pright) eine erste Vielzahl von reflektierenden Gittern (R1) umfasst, die die erste Periode aufweisen und voneinander durch einen ersten Abstand (Rg) getrennt sind;
      - die zweite Struktur (Pleft) eine zweite Vielzahl von reflektierenden Gittern (R2) umfasst, die die zweite Periode aufweisen und voneinander durch einen zweiten Abstand (Lg) getrennt sind;

   wobei der erste Abstand (Rg) kleiner ist als der zweite Abstand (Lg).

2. Filter (1) nach dem vorstehenden Anspruch, wobei die erste Struktur (Pright) vom elektroakustischen Eingangswandler (2a) um einen ersten Trennabstand (Srg) beabstandet ist, die zweite Struktur (Pleft) vom Ausgangswandler (2b) um einen zweiten Trennabstand (Slg) beabstandet ist, wobei der erste Trennabstand (Srg) kleiner ist als der zweite Trennabstand (Slg).

3. Filter (1) nach einem der vorstehenden Ansprüche, das außerdem zwei externe Spiegel (3a, 3b) umfasst, die beiderseits des Eingangs- (2a) und des Ausgangswandlers (2b) angeordnet sind.

4. Filter (1) nach einem der vorstehenden Ansprüche, wobei die reflektierenden Gitter (R1, R2) und/oder die externen Spiegel (3a, 3b) durch Metallfingermuster gebildet sind, die auf/in der Deckschicht des Verbundsubstrats (S) angeordnet sind.

5. Filter (1) nach einem der Ansprüche 1 bis 3, wobei die reflektierenden Gitter (R1, R2) und/oder die externen Spiegel (3a, 3b) durch in das Verbundsubstrat eingravierte Rillengitter gebildet sind.

6. Filter (1) nach einem der Ansprüche 1 bis 3, wobei die reflektierenden Gitter (R1, R2) und/oder die externen Spiegel (3a, 3b) durch dielektrische Fingergitter gebildet werden, die auf der Oberfläche des Verbundsubstrats (S) angeordnet sind.

7. Filter (1) nach einem der vorstehenden Ansprüche, wobei das Verbundsubstrat mindestens eine Schicht (S2) umfasst, die zwischen dem Basissubstrat (S3) und der piezoelektrischen Deckschicht (S1) angeordnet ist.

8. Filter (1) nach einem der vorstehenden Ansprüche, wobei das Basissubstrat (S3) einen elektrischen Widerstand von mehr als 1000 Ohm.cm aufweist.

9. Filter (1) nach einem der vorstehenden Ansprüche, wobei die Dicke der piezoelektrischen Deckschicht (S3) weniger als 20 Mikrometer beträgt.

10. Filter (1) nach einem der vorstehenden Ansprüche, wobei der elektroakustische Eingangswandler (2a) und der elektroakustische Ausgangswandler (2b) jeweils aus zwei ineinandergreifenden Kammelektroden bestehen.

11. Filter (1) nach einem der vorstehenden Ansprüche, wobei der Abstand (Pcg) zwischen der ersten Struktur (Pright) und der zweiten Struktur (Pleft) dem arithmetischen Mittelwert des ersten Abstands (Rg) und des zweiten Abstands (Lg) mit einer Genauigkeit von 10 % entspricht.

**Claims**

1. Resonant cavity surface elastic wave filter (1) comprising:

- a composite substrate (S) formed of a base substrate (S3) and a piezoelectric upper layer (S1);
- at least one input electroacoustic transducer (2a) and one output electroacoustic transducer (2b), arranged on the upper layer;
- at least one internal reflective structure, arranged between the input electroacoustic transducer (2a) and the output electroacoustic transducer (2b), the internal reflective structure comprising:

    - a first structure (Pright) comprising at least one reflective grating (R1) having a first period;
    - a second structure (Pleft) comprising at least one reflective grating (R2) having a second period,

the first period being greater than the second period; the filter being **characterised in that**:

    - the first structure (Pright) comprises a first plurality of reflective gratings (R1) having the first period, separated from each other by a first distance (Rg);
    - the second structure (Pleft) comprises a second plurality of reflective gratings (R2) having the second period, separated from each other by a second distance (Lg);

the first distance (Rg) being less than the second distance (Lg).

2. Filter (1) according to the preceding claim, wherein the first structure (Pright) is distant from the input electroacoustic transducer (2a) by a first separation distance (Srg), the second structure (Pleft) is distant from the output transducer (2b) by a second separation distance (Slg), the first separation distance (Srg) being less than the second separation distance (Slg).

3. Filter (1) according to any one of the preceding claims, further comprising two external mirrors (3a, 3b) arranged on either side of the input (2a) and output (2b) transducers.

4. Filter (1) according to any one of the preceding claims, wherein the reflective gratings (R1, R2) and/or the external mirrors (3a, 3b) are formed by gratings of metal fingers arranged on/in the upper layer of the composite substrate (S).

5. Filter (1) according to any one of claims 1 to 3, wherein the reflecting gratings (R1, R2) and/or the external mirrors (3a, 3b) are formed by arrays of grooves etched in the composite substrate.

6. Filter (1) according to one of Claims 1 to 3, wherein the reflective gratings (R1, R2) and/or the external mirrors (3a, 3b) are formed by arrays of dielectric fingers arranged on the surface of the composite substrate (S).

7. Filter (1) according to any one of the preceding claims, wherein the composite substrate comprises at least one layer (S2) arranged between the base substrate (S3) and the piezoelectric upper layer (S1).

8. Filter (1) according to any one of the preceding claims, wherein the base substrate (S3) has an electrical resistivity greater than 1000 Ohm.cm.

9. Filter (1) according to any one of the preceding claims, wherein the thickness of the upper piezoelectric layer (S3) is less than 20 microns.

10. Filter (1) according to any one of the preceding claims, wherein the input electroacoustic transducer (2a) and the output electroacoustic transducer (2b) respectively consist of two interdigitated comb electrodes.

11. Filter (1) according to any one of the preceding claims, wherein the distance (Pcg) separating the first structure (Pright) and the second structure (Pleft) is equal to the arithmetic mean, to within 10%, of the first distance (Rg) and the second distance (Lg).

[Fig. 1]

[Fig. 2a]

[Fig. 2b]

[Fig. 3a]

[Fig. 3b]

[Fig. 3c]

[Fig. 3d]

[Fig. 4a]

[Fig. 4b]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0608249 A
- EP 3599720 A
- DE 2363701
- WO 2020021029 A

**Littérature non-brevet citée dans la description**

- **DAVID P. MORGAN**. Surface acoustic wave filters with application to electronic communications and signal processing. Academic Press, 09 August 2007